# EUROPEAN PATENT APPLICATION

(11) **EP 4 608 108 A1**
(43) Date of publication of application: **27.08.2025**
(21) Application number: 24883633.0
(22) Date of filing: 20.12.2024
(51) Int. Cl.: H10K 59/12

(54) **OLED DISPLAY PANEL AND PREPARATION METHOD THEREFOR, AND DISPLAY APPARATUS**

(30) Priority: 29.12.2023 CN 202311852120
(71) Applicant: Xi'an Smart Materials Co., Ltd., Xi'an, Shaanxi 712099 (CN)
(72) Inventor: LEI, Ting, Xi'an, Shaanxi 712099 (CN); ZHOU, Ping, Xi'an, Shaanxi 712099 (CN)
(74) Representative: Zacco GmbH
(86) International application number: PCT/CN2024/141141
(87) International publication number: WO 2025/140052

(57) **Abstract**

The present invention belongs to the technical field of display, and particularly discloses an OLED display panel and a preparation method thereof, and a display apparatus. The display panel includes, from bottom to top in sequence, a substrate, a pixel unit layer, a thin film encapsulation layer and a micro-lens layer, wherein the micro-lens layer includes a plurality of micro-lens convex bodies that are distributed in an array on the thin film encapsulation layer, and a planarization layer covering all of the plurality of micro-lens convex bodies, the refractive index of each of the plurality of micro-lens convex bodies is greater than the refractive index of the planarization layer, meanwhile, the distance between any two adjacent micro-lens convex bodies is 0 to 20 µm, and light-emitting units in the pixel unit layer are disposed in one-to-one correspondence with micro-lens units formed by the plurality of micro-lens convex bodies. In the present invention, more large-angle light rays may be converted into small-angle light rays by refraction and reflection through the plurality of micro-lens convex bodies, so that the light rays is emitted from the upper side of the micro-lens layer, thereby greatly improving the luminous efficiency of the OLED display panel without changing a light path under a positive angle of view of the light-emitting unit, reducing the power consumption, and prolonging the service life.

## Description

The present invention claims the priority of Chinese Patent Application 202311852120.X, filed in the China National Intellectual Property Administration on December 29, 2023, and entitled "OLED Display Panel and Preparation Method Thereof, and Display Apparatus".

### Technical Field

The present invention relates to the technical field of display, and in particular to an OLED display panel and a preparation method thereof, and a display apparatus.

### Background

With the continuous development of the display technology, the display panel manufacturing technology also tends to be mature. An existing display panel mainly includes a liquid crystal display (LCD) panel, a plasma display panel (PDP), and an organic light emitting diode (OLED) display panel, wherein compared with other display panels, the OLED display panel has many advantages, for example, being lighter and thinner, high in brightness, wide in angle of view, low in power consumption, fast in response, high in definition, good in flexibility, high in luminous efficiency, and the like, and thus the OLED display panel gradually becomes a mainstream display technology.

In an OLED display panel of a conventional structure, due to the difference of optical properties of different functional layer materials, light is lost inside a device in the form of total reflection, only about 20% to 30% of light emitted from an OLED organic light-emitting layer may be emitted from glass, and most of the light is lost in an organic material thin film and a glass substrate in a guided wave mode, for example, the light generating Fresnel reflection (when the line of sight is perpendicular to a surface, the reflection is weaker, and when the line of sight is not perpendicular to the surface, the smaller the included angle is, the more obvious the reflection is) between film layers is lost, thus affecting the luminous efficiency and the display effect of the OLED display panel.

In the related art, in order to enhance the luminous efficiency and the display effect of the OLED display panel, a micro-lens is usually disposed in the OLED display panel to prevent the case where a part of light emitted from a plurality of sub-pixels generates total reflection after reaching an encapsulation layer and thus this part of light may not be emitted and is lost inside a device or is emitted from an edge, that is, a light concentration function is achieved by the micro-lens, thereby improving the front-face luminous efficiency and the display effect of the OLED display panel to a certain extent. However, under a large angle of view, due to different degrees of light intensity concentration of the micro-lens for pixel units, the degrees of attenuation of the light emitted from the pixel units are different, so that the OLED display panel still has low luminous efficiency under different degrees, thus causing a waste of light, and generating high energy consumption.

In view of this, the present invention is proposed.

### Summary

Some embodiments of the present invention are to overcome the shortcomings of the related art, and to provide an OLED display panel and a preparation method thereof, and a display apparatus, which are mainly configured to solve the problems of low luminous efficiency, waste of light and high energy consumption of an existing OLED display panel after using a micro-lens.

Some embodiments of the present invention are disclosed by the following technical solutions:
In an embodiment of the present invention, a preparation method of an OLED display panel is provided, wherein the preparation method includes the following steps:
S1, providing a substrate;
S2, forming a pixel unit layer on the substrate, wherein the pixel unit layer includes a plurality of light-emitting units arranged in an array;
S3, forming a thin film encapsulation layer on the pixel unit layer; and
S4, forming a micro-lens layer on the thin film encapsulation layer via a photolithography process, wherein the micro-lens layer includes a plurality of micro-lens convex bodies that are uniformly distributed on the thin film encapsulation layer, and a planarization layer covering the plurality of micro-lens convex bodies, and the plurality of light-emitting units are disposed in one-to-one correspondence with micro-lens units formed by the plurality of micro-lens convex bodies.

In an embodiment, the method further includes the following steps:
S5, forming a polarizer on the micro-lens layer; and
S6, forming a cover window on the polarizer.

In one implementation, the plurality of micro-lens convex bodies are distributed in an array on the thin film encapsulation layer, and micro-lens convex bodies in adjacent rows of the plurality of micro-lens convex bodies are arranged in an aligned manner or a staggered manner.

In one implementation, each of the plurality of micro-lens convex bodies is mainly made of acrylic resin and/or epoxy acrylic resin and/or epoxy resin. Of course, other materials capable of being subjected to photolithography by using a photolithography method are also included, and are not listed one by one herein.

In one implementation, the plurality of micro-lens convex bodies includes scattering particles having a particle size of 1 nm to 100 nm, and the refractive index of the scattering particles is greater than or equal to 1.7. In an embodiment, the scattering particles are inorganic matter particles, which may specifically be one or a combination of more of ZnO, TiO₂, ZnS, ZnSe and ZrO₂.

In another embodiment of the present invention, an OLED display panel is provided, includes a substrate, a pixel unit layer, a thin film encapsulation layer and a micro-lens layer, which are sequentially disposed from bottom to top, wherein the micro-lens layer includes a plurality of micro-lens convex bodies that are uniformly distributed on the thin film encapsulation layer, and a planarization layer covering the plurality of micro-lens convex bodies, the refractive index of each of the plurality of micro-lens convex bodies is greater than the refractive index of the planarization layer, meanwhile, the distance between any two adjacent micro-lens convex bodies of the plurality of micro-lens convex bodies is 0 to 20 µm, and light-emitting units in the pixel unit layer are disposed in one-to-one correspondence with micro-lens units formed by the plurality of micro-lens convex bodies.

In one implementation, the height of the plurality of micro-lens convex bodies is less than or equal to the height of the planarization layer. In an embodiment, each of the plurality of micro-lens convex bodies has a height of 0.1 µm to 20 µm and a length of 0.5 µm to 10 µm.

In one implementation, the refractive index of the plurality of micro-lens convex bodies is greater than the refractive index of the planarization layer. In an embodiment, the refractive index of the planarization layer is 1.4 to 1.48, and the refractive index of the plurality of micro-lens convex bodies is 1.65 to 1.8.

In one implementation, an orthographic projection area of the plurality of micro-lens convex bodies in each of the micro-lens units on the substrate covers an orthographic projection area of one of the plurality of light-emitting units. In this way, the micro-lens unit is configured for transmitting the light emitted from the corresponding light-emitting unit, and since the orthographic projection area of the plurality of micro-lens convex bodies on the display substrate covers the orthographic projection area of one of the plurality of light-emitting units, the flux of the output parallel light is able to be increased, thereby utilizing the light-emitting area of each of the plurality of light-emitting units more efficiently.

In one implementation, the cross section of each of the plurality of micro-lens convex bodies is semicircular, triangular or semi-rounded rectangular. When the cross section of a micro-lens convex body is semicircular or triangular, an orthographic projection of the micro-lens convex body is circular; and when the cross section of a micro-lens convex body is semi-rounded rectangular, the orthographic projection of the micro-lens convex body is semi-rounded rectangular.

In one implementation, the pixel unit layer includes, from bottom to top in sequence, a first insulating buffer layer, a second insulating buffer layer, a passivation layer, driving transistors, a pixel defining layer and the plurality of light-emitting units, the driving transistors are disposed on the first insulating buffer layer, and the second insulating buffer layer and the passivation layer in a penetrating manner and are disposed in one-to-one correspondence with the plurality of light-emitting units. In this way, the first insulating buffer layer and the second insulating buffer layer planarize the surface of a layer where the driving transistors are located;
the driving transistor includes an active layer, a gate electrode located on the active layer, and a source electrode and a drain electrode, which are respectively in contact with the active layer, the active layer is disposed on the first insulating buffer layer, and the gate electrode is disposed on the second insulating buffer layer;
the pixel defining layer is disposed around each of the plurality of light-emitting units, and is configured for defining the position of each of the plurality of light-emitting units, so as to avoid crosstalk formed by light emitted from light-emitting functional layers of different light-emitting units; and
the light-emitting unit includes a first electrode layer, a light-emitting functional layer and a second electrode layer, which are sequentially disposed in a direction away from the substrate, and the first electrode layer is connected with the drain electrode.

In one implementation, the thin film encapsulation layer includes, from bottom top in sequence, a first inorganic layer, an organic layer and a second inorganic layer, which are disposed in a stacked manner, and the first inorganic layer is disposed on the second electrode layer.

In one implementation, the OLED display panel is prepared by the above method.

In yet another embodiment of the present invention, a display apparatus is provided, wherein the display apparatus uses the above OLED display panel.

Compared with the related art, the present invention has the following beneficial effects:
1. The OLED display panel provided in the present invention is mainly composed of the substrate, the pixel unit layer, the thin film encapsulation layer and the micro-lens layer, the micro-lens layer includes the plurality of micro-lens convex bodies that are distributed in an array on the thin film encapsulation layer, and the planarization layer covering all of the plurality of micro-lens convex bodies, the refractive index of the plurality of micro-lens convex bodies is greater than the refractive index of the planarization layer, the plurality of light-emitting units in the pixel unit layer are disposed in one-to-one correspondence with the micro-lens units formed by the plurality of micro-lens convex bodies, that is, inclined light rays are refracted and converged on a contact surface of the plurality of micro-lens convex bodies and the planarization layer by using the principle of a convex lens, and the plurality of micro-lens convex bodies correspond to one light-emitting unit, so that the inclined light rays having a large angle of view and emitted from the light-emitting unit are converged into a small angle of view, so as to reduce the opportunity of total reflection of the light and improve the luminous efficiency, thereby improving the luminous effect of the OLED display panel, and effectively improving the brightness under a front angle of view of the OLED display panel. Therefore, under the same brightness conditions, due to the high luminous efficiency, the power consumption is low, and better energy conversion is achieved.
2. According to the OLED display panel provided in the present invention, a plurality of micro-lens convex bodies having a distance of 0-20 µm are disposed in an array directly above each of the plurality of light-emitting units, thereby being easy to form and reducing the process difficulty. Meanwhile, a high-refractive-index film layer is made into the plurality of micro-lens convex bodies to achieve the effect of relieving the residual stress of the high-refractive-index film layer, thereby avoiding the problem of encapsulation layer Peeling failure when the high-refractive-index film coated on the whole surface in an MLA structure is subjected to a reliability test, and improving the stability and the service life of the OLED display panel.

### Brief Description of the Drawings

The drawings herein are incorporated into and constitute a part of the present specification, and are used to explain the principles of the present invention together with the specification.

To illustrate technical solutions in the embodiments of the present invention or in the related art more clearly, a brief introduction on the drawings which are needed in the description of the embodiments or the related art is given below. Apparently, for those ordinary skilled in the art, other drawings may also be obtained according to these drawings without any creative effort.
Fig. 1 is a schematic diagram of a sectional structure of an OLED display panel in Embodiment 1 of the present invention;
Fig. 2 is a schematic diagram of a partial sectional structure when the cross section of a micro-lens convex body is triangular in Embodiment 1 of the present invention;
Fig. 3 is a schematic diagram of a partial sectional structure when the cross section of a micro-lens convex body is semielliptic in Embodiment 1 of the present invention;
Fig. 4 is a schematic diagram of a position relationship between a micro-lens convex body and a light-emitting unit in Embodiment 1 of the present invention;
Fig. 5 is a schematic diagram of another position relationship between a micro-lens convex body and a light-emitting unit in Embodiment 1 of the present invention;
Fig. 6 is a schematic diagram of a partial sectional structure when the cross section of a micro-lens convex body is semi-rounded rectangular in Embodiment 2 of the present invention;
Fig. 7 is a schematic diagram of a position relationship between a micro-lens convex body and a light-emitting unit in Embodiment 2 of the present invention; and
Fig. 8 is a schematic diagram of another position relationship between a micro-lens convex body and a light-emitting unit in Embodiment 2 of the present invention.

Wherein:
10. substrate;
20. pixel unit layer; 21. first insulating buffer layer; 22. second insulating buffer layer; 23. passivation layer; 24. driving transistor; 24-1. active layer; 24-2. gate electrode; 24-3. source electrode; 24-4. drain electrode; 25. pixel defining layer; 26. light-emitting unit; 26-1. first electrode layer; 26-2. light-emitting functional layer; 26-3. second electrode layer;
30. thin film encapsulation layer; 31. first inorganic layer; 32. organic layer; 33. second inorganic layer;
40. touch electrode layer;
50. micro-lens layer; 51. micro-lens convex body; 52. planarization layer;
60. polarizer;
70. cover window.

### Detailed Description of the Embodiments

Exemplary embodiments will be described herein in detail, and examples of which are illustrated in the drawings. When the following description involves the drawings, unless otherwise represented, the same numbers in different drawings represent the same or similar elements. The implementations described in the following exemplary embodiments do not represent all implementations consistent with the present invention. Instead, they are merely examples of apparatuses that are consistent with some aspects of the present invention as detailed in the appended claims.

To enable those skilled in the art to better understand the technical solutions of the present invention, the present invention will be further described in detail below in combination with the drawings and embodiments.

### Embodiment 1

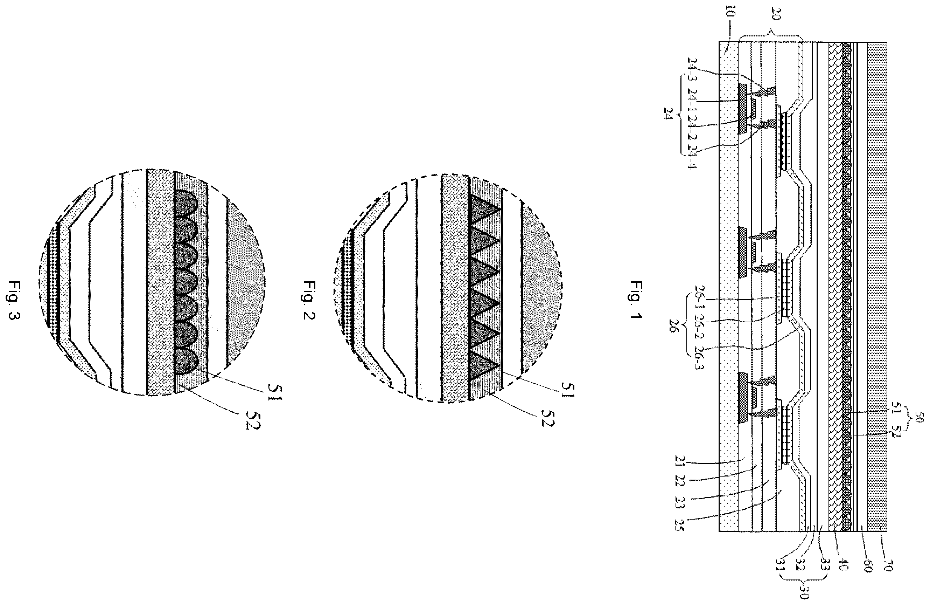

Referring to Figs. 1 to 5, an embodiment of the present invention provides an OLED display panel, at least including, from bottom to top in sequence, a substrate 10, a pixel unit layer 20, a thin film encapsulation layer 30 and a micro-lens layer 50, wherein the micro-lens layer 50 includes a plurality of micro-lens convex bodies 51 that are uniformly distributed on the thin film encapsulation layer 30, and a planarization layer covering all of the plurality of micro-lens convex bodies 51, the plurality of micro-lens convex bodies 51 fully cover the entire thin film encapsulation layer 30, light-emitting units 26 in the pixel unit layer 20 are disposed in one-to-one correspondence with micro-lens units formed by the plurality of micro-lens convex bodies 51, and the refractive index of each of the plurality of micro-lens convex bodies 51 is greater than the refractive index of the planarization layer 52.

Specifically, in the embodiment of the present invention, the substrate 10 is located on a bottommost layer of the display panel, and the substrate 10 may be an insulating substrate made of glass, quartz, transparent plastic and the like, or a metal substrate made of stainless steel and the like, wherein the transparent plastic substrate may be formed by any of polyimide resin, acrylic resin, polypropionate resin, polycarbonate resin, or polyether resin. In addition, the substrate 10 may be flexible, stretchable, foldable, bendable and/or rollable, and may be specifically customized according to actual needs.

In the embodiment of the present invention, the pixel unit layer 20 includes, from bottom to top in sequence, a first insulating buffer layer 21, a second insulating buffer layer 22, a passivation layer 23, driving transistors 24, a pixel defining layer 25 and light-emitting units 26, and the driving transistors 24 are disposed on the first insulating buffer layer 21, the second insulating buffer layer 22 and the passivation layer 23 in a penetrating manner and are disposed in one-to-one correspondence with the plurality of light-emitting units 26, wherein the first insulating buffer layer 21 and the second insulating buffer layer 22 may be made of inorganic insulating materials such as silicon oxide, silicon nitride and silicon oxynitride, or may be made of organic insulating materials such as polyimide, polyphthalimide, polyamide, acrylic resin, benzocyclobutene or phenolic resin, which is not specifically limited in the present invention, and the purpose thereof is to planarize the surface of a layer where the driving transistors 24 are located. The passivation layer 23 is configured for protecting the structures of other layers below same, so as to delay the corrosion speed.

Specifically, in the embodiment of the present invention, the driving transistor 24 includes an active layer 24-1, a gate electrode 24-2 located on the active layer 24-1, and a source electrode 24-3 and a drain electrode 24-4, which are respectively in contact with the active layer 24-1, the active layer 24-1 is disposed on the first insulating buffer layer 21, and the gate electrode 24-2 is disposed on the second insulating buffer layer 22. The pixel defining layer 25 is disposed around each of the plurality of light-emitting units 26, and is configured for defining the position of each of the plurality of light-emitting units 26, so as to avoid crosstalk formed by light emitted from different light-emitting units 26. The light-emitting unit 26 includes a first electrode layer 26-1, a light-emitting functional layer 26-2 and a second electrode layer 26-3, which are sequentially disposed in a direction away from the substrate 10, and the first electrode layer 26-1 is connected with the drain electrode 2-4; and the light-emitting unit 26 includes a red light-emitting unit 26 (R), a green light-emitting unit 26 (G) and a blue light-emitting unit 26 (B), which may respectively emit red light, green light and blue light.

In an embodiment, the first electrode layer 26-1 may be a laminated structure formed by an ITO/Ag/ITO material; and the material of the second electrode layer 26-3 may include Ag and/or Mg. Specifically, in the present embodiment, the first electrode layer 26-1 uses a laminated structure formed by an ITO material; and the material of the second electrode layer 26-3 uses a single-layer structure of Ag. The light-emitting functional layer 26-2 may be a micromolecular single-layer or multi-layer OLED device, or a macromolecular single-layer or multi-layer OLED device, and may be actually selected according to the requirements of each product for luminance and luminous efficiency. In the present embodiment, an organic light emitting diode (OLED) thin film device is taken as an example, the OLED may include an electron inject layer (EIL), an electron transport layer (ETL), an electron barrier layer, a hole transport layer (HTL), a hole inject layer (HIL), and/or a hole barrier layer, which are disposed in the stacked manner.

In the embodiment of the present invention, the thin film encapsulation layer 30 includes a first inorganic layer 31, an organic layer 32 and a second inorganic layer 33, which are stacked in sequence from bottom to top, and the first inorganic layer 31 is disposed on the second electrode layer 26-3. By using the sequential stacking manner, the smooth characteristic among the first inorganic layer 31, the organic layer 32 and the second inorganic layer 33 is ensured, and meanwhile, defects of the second inorganic layer 33 are prevented from diffusing into the first inorganic layer 31.

The first inorganic layer 31 and the second inorganic layer 33 may be made of the same or different inorganic materials. Specifically, the inorganic material is one or more of silicon oxide (SiOₓ), silicon nitride (SiNₓ), silicon oxynitride (SiOₓN_{y}), ZnSe, ZnO, Sb₂O₃, Al₂O₃, In₂O₃ or SnO₂, wherein the values of x and y in the formulas range from 1 to 5. The first inorganic layer 31 and the second inorganic layer 33 each has a thickness of 40 nm to 1000 nm and a refractive index of 1.41 to 2.0.

In the embodiment of the present invention, the organic layer 32 is made of an acrylate or an epoxy polymer, the organic layer 32 has a thickness of 0.2 µm to 15 µm and a refractive index 1.4 to 1.65, the organic layer 32 may block external moisture or oxygen permeation, and by blocking the defects of the inorganic layer, the inorganic layer may be planarized to ensure the light extraction rate.

It should be noted that in the embodiment of the present invention, the micro-lens layer 50 includes a plurality of micro-lens convex bodies 51 that are distributed in an array on the thin film encapsulation layer 30, and a planarization layer 52 covering all of the plurality of micro-lens convex bodies 51, the height of the plurality of micro-lens convex bodies 51 is less than or equal to the height of the planarization layer 52, meanwhile, the distance between any two adjacent micro-lens convex bodies 51 is 0 to 20 µm, and a plurality of micro-lens convex bodies 51 form one micro-lens unit.

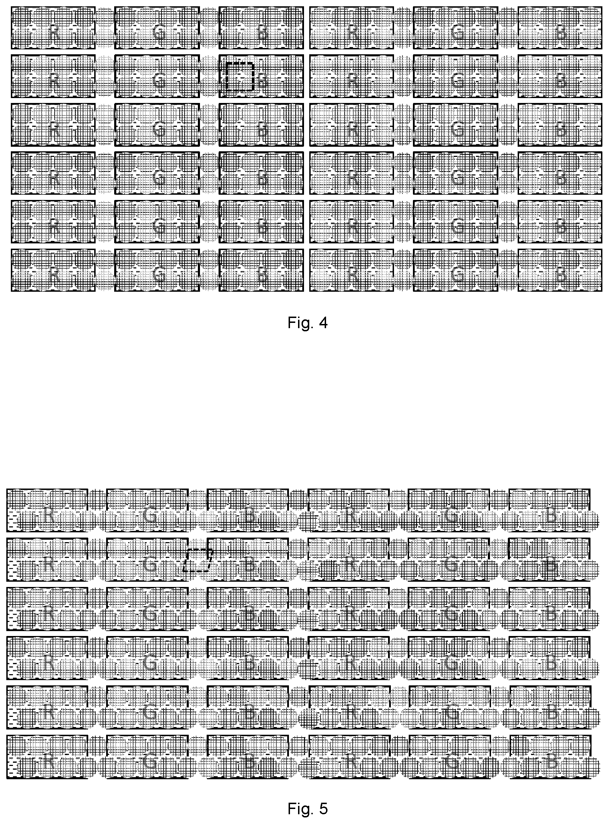

Since the light emitted from the light-emitting unit 26 is light having a certain divergence angle, there is a relatively large probability that the large-angle light will dissipate after undergoing total reflection or multiple times of refraction, which seriously affects the luminous efficiency of the OLED display panel. To this end, in the embodiment of the present invention, an orthographic projection area of the plurality of micro-lens convex bodies 51 in each of the micro-lens units on the substrate 10 is just configured to cover an orthographic projection area of one of the plurality of light-emitting units 26, as shown in Fig. 4 and Fig. 5. In an embodiment, the distance between two adjacent micro-lens convex bodies 51 is 0, that is, the plurality of micro-lens convex bodies abut against each other to be disposed in an array of multiple rows and multiple columns; the plurality of micro-lens convex bodies 51 are arranged in multiple rows, the micro-lens convex bodies 51 in adjacent rows are arranged in an aligned manner, four micro-lens convex bodies 51 are simultaneously selected from adjacent rows to form a square structure, as shown in Fig. 4; or the plurality of micro-lens convex bodies 51 are arranged in multiple rows, the micro-lens convex bodies 51 in adjacent rows are arranged in a staggered manner, and four micro-lens convex bodies 51 are simultaneously selected in adjacent rows to form a parallelogram structure, as shown in Fig. 5. In this way, the flux of the output parallel light is able to be increased, thereby utilizing the light-emitting area of each of the plurality of light-emitting units 26 more efficiently. That is, in the present invention, more large-angle light rays may be converted into small-angle light rays by refraction and reflection through the specially disposed micro-lens convex bodies 51, so that the light is emitted from the upper side of the micro-lens layer 50, without altering the light path at the front viewing angle of the light-emitting unit 26, thereby significantly improving the light extraction efficiency of the OLED display panel and reducing power consumption, and the service life of the OLED display panel is able to be prolonged.

In an embodiment, in the embodiment of the present invention, the refractive index of the planarization layer 52 is generally set to be 1.4 to 1.48, and the refractive index of the plurality of micro-lens convex bodies 51 is 1.65 to 1.8. In another embodiment, the plurality of micro-lens convex bodies 51 includes scattering particles having a particle size of 1 nm to 100 nm, and the refractive index of the scattering particles is greater than or equal to 1.7; and the scattering particles are inorganic matter particles, which may specifically be one or a combination of more of ZnO, TiO₂, ZnS, ZnSe and ZrO₂.

In the embodiment of the present invention, the plurality of micro-lens convex bodies 51 are mainly made of acrylic resin and/or epoxy acrylic resin, and the cross section of the micro-lens convex body 51 is triangular (the corresponding micro-lens convex body 51 is a cone), as shown in Fig. 2; or the cross section of the micro-lens convex body 51 is semielliptic (a special case of semicircular), as shown in Fig. 3. When the cross section of the micro-lens convex body 51 is triangular or semielliptic, an orthographic projection corresponding thereto is circular. In an embodiment, each of the plurality of micro-lens convex bodies 51 has a height of 0.1 µm to 20 µm and a length of 0.5 µm to 10 µm. In another embodiment, the distance between two adjacent micro-lens convex bodies 51 is consistent with the length thereof.

Preferably, in the embodiment of the present invention, the OLED display panel further includes a touch electrode layer 40 disposed between the thin film encapsulation layer 30 and the micro-lens layer 50, the touch electrode layer 40 may be set as a grid electrode, and grid lines of the grid electrode are located in gaps among the plurality of light-emitting units 26. In another embodiment, the OLED display panel may further include a polarizer 60 disposed on the micro-lens layer 50, and a cover window 70 disposed on the polarizer 60, and the cover window 70 mainly protects the OLED display panel from external interference, and may be formed by a single layer or a plurality of layers.

In addition, the present invention further provides a preparation method of an OLED display panel, and the flows of the preparation method are as follows:
1) providing a substrate 10;
2) forming a pixel unit layer 20 on the substrate 10 in step 1), wherein the pixel unit layer 20 includes a plurality of light-emitting units 26 arranged in an array;
3) forming a thin film encapsulation layer 30 on the pixel unit layer 20 in step 2);
4) forming a micro-lens layer 50 on the thin film encapsulation layer 30 via a photolithography process, wherein the micro-lens layer 50 includes a plurality of micro-lens convex bodies 51 that are uniformly distributed on the thin film encapsulation layer 30, and a planarization layer 52 covering the plurality of micro-lens convex bodies 51, and the plurality of light-emitting units 26 are disposed in one-to-one correspondence with micro-lens units formed by the plurality of micro-lens convex bodies 51, and the distance between any two adjacent micro-lens convex bodies 51 is 0 to 20 µm;
5) forming a polarizer 60 on the micro-lens layer 50 in step 4); and
6) forming a cover window 70 on the polarizer 60 at step 5).

In addition, the present embodiment further provides a display apparatus, wherein the display apparatus uses the OLED display panel described above.

### Embodiment 2

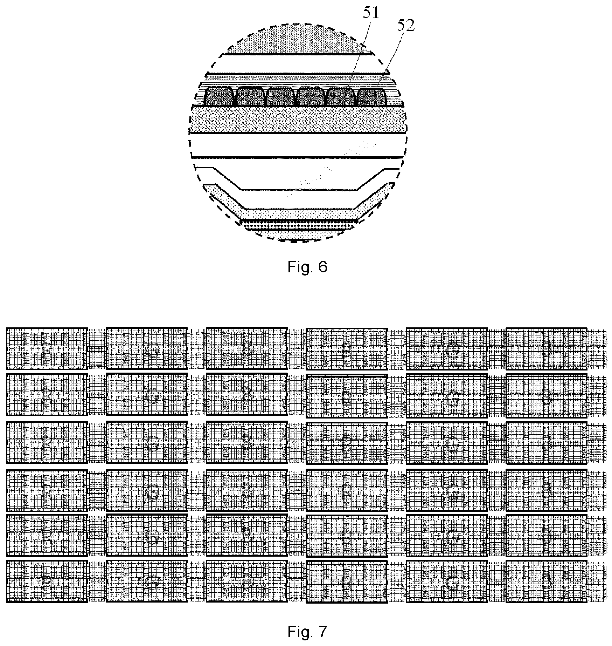

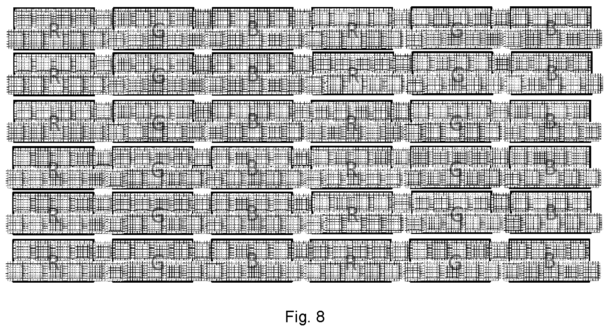

Referring to Figs. 6-8, the present embodiment provides a structure of another OLED display panel, the structure differs from the OLED display panel in Embodiment 1 only in that the shape of the cross section of the micro-lens convex body 51 is different. In the present embodiment, the cross section of the micro-lens convex body 51 is semi-rounded rectangular, and thus the orthographic projection corresponding thereto is also semi-rounded rectangular. Of course, in the present embodiment, the plurality of micro-lens convex bodies 51 are also arranged in an array on the thin-film encapsulation layer 30, the plurality of micro-lens convex bodies 51 are arranged in multiple rows, and the micro-lens convex bodies 51 in adjacent rows are arranged in an aligned manner, as shown in Fig. 7; or the micro-lens convex bodies 51 in adjacent rows are arranged in a staggered manner, as shown in Fig. 8, the light-emitting area of each of the plurality of light-emitting units 26 may be effectively utilized according to actual needs.

The foregoing descriptions are merely specific implementations of the present invention, and are intended to enable those skilled in the art to understand or implement the present invention. Various modifications to these embodiments will be apparent to those skilled in the art, and the general principles defined herein may be implemented in other embodiments without departing from the spirit or scope of the present invention.

It should be understood that the present invention is not limited to the content described above, and various modifications and changes may be made without departing from the scope thereof. The scope of the present invention is limited only by the appended claims.

## Claims

1. A preparation method of an OLED display panel, wherein the preparation method comprises the following steps:
S1, providing a substrate (10);
S2, forming a pixel unit layer (20) on the substrate (10), wherein the pixel unit layer (20) comprises a plurality of light-emitting units (26) arranged in an array;
S3, forming a thin film encapsulation layer (30) on the pixel unit layer (20); and
S4, forming a micro-lens layer (50) on the thin film encapsulation layer (30) via a photolithography process, wherein the micro-lens layer (50) comprises a plurality of micro-lens convex bodies (51) that are uniformly distributed on the thin film encapsulation layer (30), and a planarization layer (52) covering the plurality of micro-lens convex bodies (51), and the plurality of light-emitting units (26) are disposed in one-to-one correspondence with micro-lens units formed by the plurality of micro-lens convex bodies (51).

2. The preparation method of the OLED display panel as claimed in claim 1, wherein the plurality of micro-lens convex bodies (51) are distributed in an array on the thin film encapsulation layer (30), and micro-lens convex bodies in adjacent rows of the plurality of micro-lens convex bodies (51) are arranged in an aligned manner or a staggered manner.

3. The preparation method of the OLED display panel as claimed in claim 1, wherein the plurality of micro-lens convex bodies (51) are mainly made of acrylic resin and/or epoxy acrylic resin and/or epoxy resin.

4. The preparation method of the OLED display panel as claimed in claim 1, wherein the plurality of micro-lens convex bodies (51) comprise scattering particles having a particle size of 1 nm to 100 nm, and a refractive index of each of the scattering particles is greater than or equal to 1.7.

5. An OLED display panel, wherein the OLED display panel is prepared from the preparation method of the OLED display panel as claimed in any of claims 1-4, the OLED display panel comprises the substrate (10), the pixel unit layer (20), the thin film encapsulation layer (30) and the micro-lens layer (50), which are sequentially disposed from bottom to top, the micro-lens layer (50) comprises the plurality of micro-lens convex bodies (51) that are uniformly distributed on the thin film encapsulation layer (30), and the planarization layer (52) covering the plurality of micro-lens convex bodies (51), a refractive index of each of the plurality of micro-lens convex bodies (51) is greater than a refractive index of the planarization layer (52), meanwhile, a distance between any two adjacent micro-lens convex bodies of the plurality of micro-lens convex bodies (51) is 0 to 20 µm, and the plurality of light-emitting units (26) in the pixel unit layer (20) are disposed in one-to-one correspondence with the micro-lens units formed by the plurality of micro-lens convex bodies (51).

6. The OLED display panel as claimed in claim 5, wherein an orthographic projection area of the plurality of micro-lens convex bodies (51) in each of the micro-lens units on the substrate (10) covers an orthographic projection area of one of the plurality of light-emitting units (26).

7. The OLED display panel as claimed in claim 5, wherein a cross section of each of the plurality of micro-lens convex bodies (51) is semicircular, triangular, and/or semi-rounded rectangular.

8. The OLED display panel as claimed in claim 5, wherein the pixel unit layer (20) comprises, from bottom to top in sequence, a first insulating buffer layer (21), a second insulating buffer layer (22), a passivation layer (23), driving transistors (24), a pixel defining layer (25) and the plurality of light-emitting units (26), and the driving transistors (24) are disposed on the first insulating buffer layer (21), the second insulating buffer layer (22) and the passivation layer (23) in a penetrating manner and are disposed in one-to-one correspondence with the plurality of light-emitting units (26);
each of the driving transistors (24) comprises an active layer (24-1), a gate electrode (24-2) located on the active layer (24-1), and a source electrode (24-3) and a drain electrode (24-4), which are respectively in contact with the active layer (24-1), the active layer (24-1) is disposed on the first insulating buffer layer (21), and the gate electrode (24-2) is disposed on the second insulating buffer layer (22);
the pixel defining layer (25) is disposed around each of the plurality of light-emitting units (26), and is configured for defining a position of each of the plurality of light-emitting units (26); and
each of the light-emitting units (26) comprises a first electrode layer (26-1), a light-emitting functional layer (26-2) and a second electrode layer (26-3), which are sequentially disposed in a direction away from the substrate (10), and the first electrode layer (26-1) is connected with the drain electrode (24-4).

9. The OLED display panel as claimed in claim 8, wherein,
the first electrode layer (26-1) comprises a laminated structure formed by an ITO/Ag/ITO material; and/or
a material of the second electrode layer (26-3) comprises at least one of Ag and Mg.

10. The OLED display panel as claimed in claim 8, wherein the light-emitting functional layer (26-2) comprises one of a micromolecular single-layer OLED device, a micromolecular multi-layer OLED device, a macromolecular single-layer OLED device or a macromolecular multi-layer OLED device.

11. The OLED display panel as claimed in claim 8, wherein the thin film encapsulation layer (30) comprises a first inorganic layer (31), an organic layer (32) and a second inorganic layer (33), which are sequentially disposed in a stacked manner, and the first inorganic layer (31) is disposed on the second electrode layer (26-3).

12. The OLED display panel as claimed in claim 11, wherein,
a material of the first inorganic layer (31) comprises at least one of silicon oxide (SiOₓ), silicon nitride (SiNₓ), silicon oxynitride (SiOₓN_{y}), ZnSe, ZnO, Sb₂O₃, Al₂O₃, In₂O₃ or SnO₂, and the values of x and y range from 1 to 5; and/or
a material of the second inorganic layer (33) comprises at least one of silicon oxide (SiOₓ), silicon nitride (SiNₓ), silicon oxynitride (SiOₓN_{y}), ZnSe, ZnO, Sb₂O₃, Al₂O₃, In₂O₃ or SnO₂, and the values of x and y range from 1 to 5.

13. The OLED display panel as claimed in claim 11, wherein,
a thickness of the first inorganic layer (31) is 40 nm to 1000 nm; and/or
a thickness of the second inorganic layer (33) is 40 nm to 1000 nm; and/or
a refractive index of the first inorganic layer (31) is 1.41 to 2.0; and/or
a refractive index of the second inorganic layer (33) is 1.41 to 2.0.

14. The OLED display panel as claimed in claim 11, wherein,
a material of the organic layer (32) comprises one of an acrylate or an epoxy polymer; and/or
a thickness of the organic layer (32) is 0.2 µm to 15 µm; and/or
a refractive index of the organic layer (32) is 1.4 to 1.65.

15. The OLED display panel as claimed in claim 5, wherein,
a refractive index of the planarization layer (52) is 1.4 to 1.48; and/or
a refractive index of each of the plurality of micro-lens convex bodies (51) is 1.65 to 1.8.

16. The OLED display panel as claimed in claim 5, wherein the OLED display panel further comprises a touch electrode layer (40) disposed between the thin film encapsulation layer (30) and the micro-lens layer (50), the touch electrode layer (40) comprises a grid electrode, and grid lines of the grid electrode are located in gaps among the plurality of light-emitting units (26).

17. A display apparatus, wherein the display apparatus comprises the OLED display panel as claimed in any of claims 5-16.
